# FASCICULE DE BREVET EUROPEEN

(11) **EP 2 946 251 B1**
(45) Date de publication et mention de la délivrance du brevet: **22.02.2017**
(21) Numéro de dépôt: 13803036.6
(22) Date de dépôt: 12.12.2013
(51) Int. Cl.: G04G 17/06, H05K 1/02

(54) **SUPPORT POUR CAPTEUR HORLOGER**
TRÄGER FÜR EINEN UHRSENSOR
SUPPORT FOR A TIMEPIECE SENSOR

(30) Priorité: 18.01.2013 EP 13151803
(43) Date de publication de la demande: 25.11.2015
(73) Titulaire: ETA SA Manufacture Horlogère Suisse, 2540 Grenchen (CH)
(72) Inventeur: BALMER, Raphaël, 2824 Vicques (CH); KLOPFENSTEIN, François, CH-2800 Delémont (CH)
(74) Mandataire: Goulette, Ludivine
(86) Numéro de dépôt international: PCT/EP2013/076444
(87) Numéro de publication internationale: WO 2014/111210

(56) Documents cités:
- WO-A1-2007/054557
- FR-A1- 2 388 460
- US-A1- 2010 006 327
- US-A1- 2010 035 671

## Description

La présente invention concerne un support pour capteur destiné à être monté dans une montre électromécanique.

Pour des montres bracelets pourvues de modules capteurs, par exemple des capteurs de température ou de pression, il est nécessaire d'assurer, d'une part, une fixation robuste du capteur par rapport au boîtier, et de fournir, d'autre part, des interfaces de connexion électrique vers un circuit intégré de commande.

Pour ce faire, lorsque la forme géométrique des capteurs le permet, ils peuvent être disposés dans des logements de forme correspondante aménagés dans la carrure; sinon ils sont en général fixés à une paroi latérale de la carrure par l'intermédiaire d'une pièce intermédiaire faisant office de support et d'élément de fixation. Le module capteur inclut par ailleurs en général une plaque à circuit imprimé (PCB), sur laquelle sont formées des pistes de connexion électriques par dépôt galvanique. Cette plaque contient des connecteurs électriques pour le capteur, auquel elle est physiquement reliée, et gère les connexions électriques vers le circuit intégré principal de commande, qui est disposé ailleurs à l'intérieur du boîtier, le plus souvent sur un autre PCB, notamment par l'intermédiaire d'un connecteur Zebra.

En raison des différentes pièces requises pour le montage et des différentes interfaces de connexion, l'assemblage de tels modules capteurs est relativement complexe et coûteux.

Dans le domaine des télécommunications, on connaît par ailleurs la technologie IML (« in-molding labeling ») qui consiste à former un motif conducteur sur un film. Cette technologie permet d'intégrer des antennes, dénommées antennes-film, directement sur une paroi d'un boîtier d'un terminal mobile. Le document US2010/0035671 décrit un terminal mobile pourvu d'un tel type d'antenne agencée sur une face supérieure du boîtier, et reliée à un PCB par l'intermédiaire d'un trou traversant dans lequel est injectée de la résine conductrice et un connecteur. L'agencement proposé constitue une alternative avantageuse par rapport aux antennes externes, plus susceptibles d'être endommagées, mais n'est pas transposable au domaine horloger, où les surfaces internes du boîtier ne sont pas nécessairement planes comme les films utilisés pour les antennes.

Toujours dans le domaine des télécommunications, on connaît par ailleurs la technologie d'injection par moulage tridimensionnel et de structuration laser de pistes d'interconnexion. Le document EP2557904 décrit un tel substrat pour module électronique avec pistes d'interconnexion structurées au laser intégrées en trois dimensions, visant à permettre une intégration plus facile dans un boîtier. Une telle technologie n'est toutefois pas adaptée au domaine de l'horlogerie où les dimensions sont plus réduites, notamment pour des pièces portables au poignet, et où les contraintes de positionnement sont beaucoup plus importantes.

Le document US2010/0006327 décrit un circuit à trois dimensions sur lequel des pistes électriques à trois dimensions sont réalisées. Le circuit comprend en outre des connexions électriques vers une plaque à circuit imprimé.

Il existe donc un besoin pour des modules capteurs exempts de ces limitations.

En particulier, un but de la présente invention est de fournir un support pour capteur horloger qui permette un montage plus facile et implique un nombre de pièces et d'interfaces plus restreintes.

Ces buts sont atteints grâce à un support pour capteur d'une pièce d'horlogerie, caractérisé en ce qu'il est réalisé en 3D/MID, de telle sorte qu'il présente une forme en trois dimensions et des pistes de connexion électrique intégrées, et comprend par ailleurs une interface de connexion rigide et une interface de connexion souple formée par des ressorts fils recourbés assemblés au support ou des doigts flexibles sur lesquels sont agencées des pistes de connexion électriques.

Un avantage de la solution proposée est qu'elle permet d'intégrer en une seule pièce des fonctionnalités mécaniques et électroniques pour le montage du capteur dans le boîtier d'une montre et son interconnexion avec un circuit intégré de commande, ce qui simplifie considérablement le processus d'assemblage et réduit parallèlement l'encombrement dans le boîtier.

Un autre avantage de solution de la présente invention est qu'elle permet de se dispenser de PCBs, rigides ou flexibles, et de connecteurs Zebra habituellement utilisés en horlogerie, au niveau du support de capteur, ce qui permet d'une part de supprimer des interfaces de connexion et de minimiser la résistance ohmique du module. Ainsi les pertes par effet joule sont également réduites.

Encore un autre avantage de la solution de la présente invention est qu'elle permet une meilleure flexibilité pour l'assemblage dans un boîtier de montre, le module capteur pouvant être désormais monté côté cadran et côté fond alors qu'une solution utilisant des connecteurs Zebra ne peut être montée que par le côté cadran d'une montre. Par ailleurs, le module capteur peut être assemblé intégralement de façon autonome et ainsi plus facilement délocalisé dans le boîtier, ou positionné à des endroits différents dans des boîtiers distincts.

Par ailleurs, le fait que le support pour capteur d'une pièce d'horlogerie selon l'invention comprend une première interface de connexion rigide vers le capteur, et une deuxième interface de connexion souple destinée à être connectée à un circuit intégré de commande, présente l'avantage de requérir une précision moindre pour le positionnement du module capteur dans la boîte, les connecteurs souples pouvant récupérer des jeux de fonctionnement importants, au contraire d'un PCB.

D'autres caractéristiques et avantages de l'invention ressortiront plus clairement de la description détaillée et des dessins, dans lesquels:
- la figure 1A montre une vue d'une première face d'un support de capteur pour pièce d'horlogerie selon un premier mode de réalisation préférentiel, sur laquelle est agencée un logement pour le capteur et l'interface de connexion avec ce capteur;
- la figure 1B montre le support de capteur de la figure 1A, avec le capteur assemblé dans son logement;
- la figure 2A montre une vue de la face opposée du support de capteur selon le mode de réalisation préférentiel illustré à la figure 1A, sur laquelle est agencée l'interface de connexion vers un circuit intégré externe;
- la figure 2B montre une vue de la face du support de capteur selon le mode de réalisation préférentiel illustré par la figure 2A, mettant en évidence la forme et le positionnement de ressorts fils;
- la figure 2C montre le support de capteur selon le mode de réalisation préférentiel illustré à la figure 2B, avec tous les ressorts fils assemblés et des pieds de fixation insérés dans les échancrures latérales;
- la figure 3 représente un support de capteur pour pièce d'horlogerie selon un deuxième mode de réalisation préférentiel, comprenant des doigts flexibles sur lesquels sont agencés des pistes de connexions électriques structurées au laser.

La technologie 3D/MID, qui est un acronyme pour « moulded interconnect device » en trois dimensions (« 3D »), consiste à fabriquer une pièce en plastique injecté contenant des pistes de connexion électroniques intégrées, réalisées notamment grâce à une technique de structuration au laser appelée LDS - acronyme pour « laser direct structuring ». Dans une première étape, la forme géométrique en trois dimensions de la pièce est déterminée par la forme d'un moule, dans lequel on injecte une première matière non conductrice mais spécifiquement optimisée pour le procédé LDS. Puis on structure par laser les surfaces qui deviendront les pistes de connexion sur la pièce injectée. Finalement la pièce ainsi formée subit un traitement de métallisation chimique, au cours duquel seules les surfaces précédemment exposées au laser vont pouvoir accrocher la métallisation. Cette technique permet une flexibilité accrue pour le design de pièces en vue de leur intégration dans des appareils de forme donnée, comme par exemple des antennes pour téléphones portables, pour lesquels les contraintes sont de plus en plus pointues en termes de volume. Elle permet par ailleurs une optimisation du processus de production de composants électroniques avec de meilleurs rendements pour une production de masse. Alternativement à la technique LDS décrite ci-dessus, les pièces 3D/MID peuvent également être réalisées par d'autres procédés, et notamment par une technique d'injection bi-matière, dite aussi "moulage par injection à deux composants". Cette méthode utilise deux matériaux plastiques, dont l'un peut être métallisé pour créer les pistes d'interconnexion électrique, tandis que l'autre matériau reste passif. Cette technique à deux composants (2C) nécessite un investissement plus élevé que la technique LDS, mais permet éventuellement de réduire encore les coûts par pièce pour de gros volumes de production. D'autres techniques sont également envisageables, comme par exemple une métallisation directe à l'argent par pulvérisation aérosol, suivie d'un procédé de frittage.

L'emploi d'un support de capteur fabriqué grâce à une technologie 3D/MID dans le cadre de l'invention pour une pièce d'horlogerie permet d'une part de se dispenser d'un support de capteur dédié, de forme usuellement plane, ce qui résulte en un gain de place et une simplification du processus d'assemblage, et d'autre part d'un connecteur Zebra habituellement employé pour la connexion au circuit intégré de commande, ce qui minimise les interfaces de connexion et donne plus de flexibilité pour le positionnement du module capteur dans le boîtier.

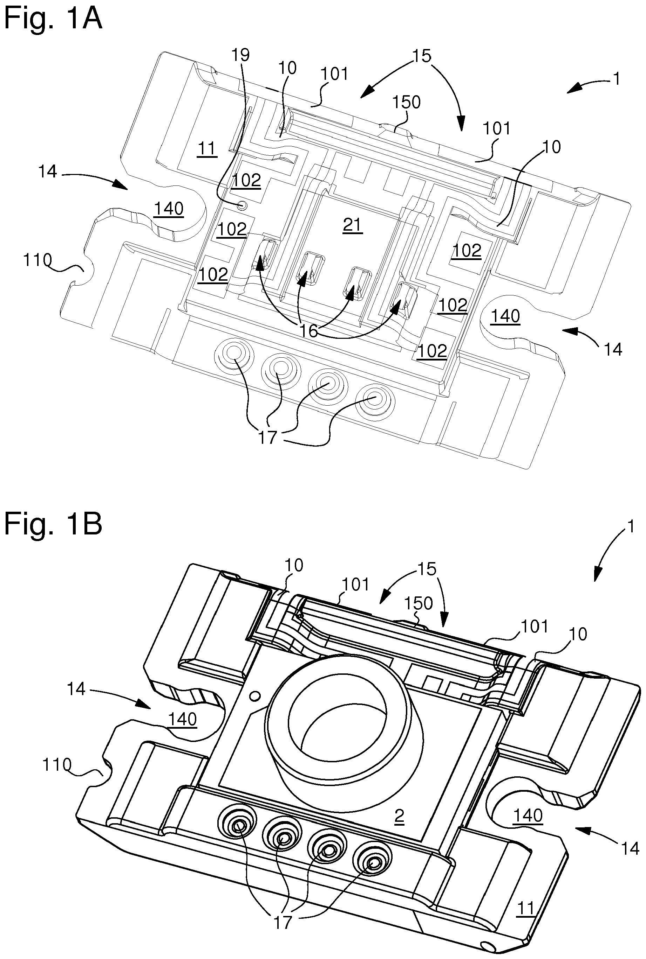

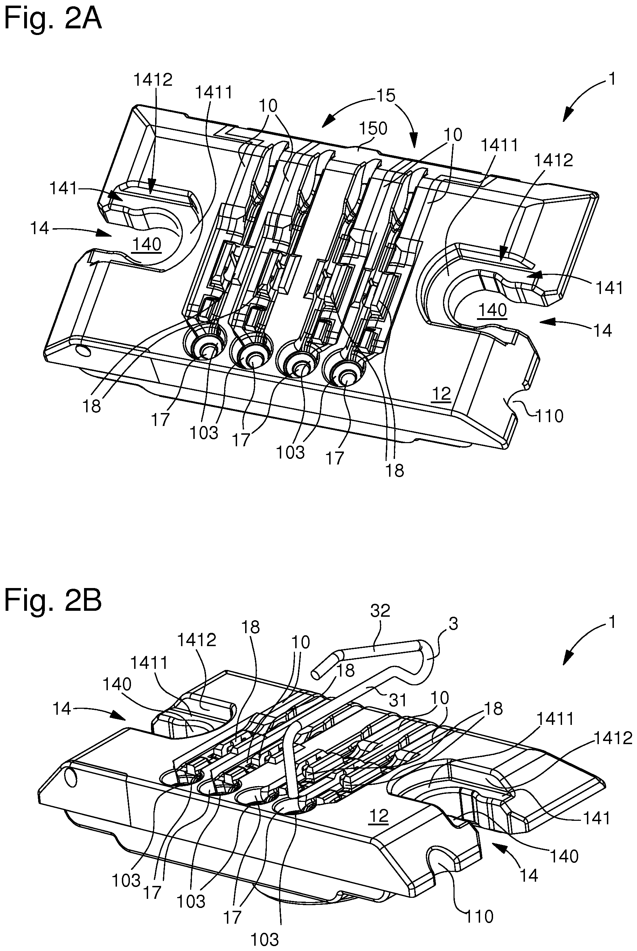

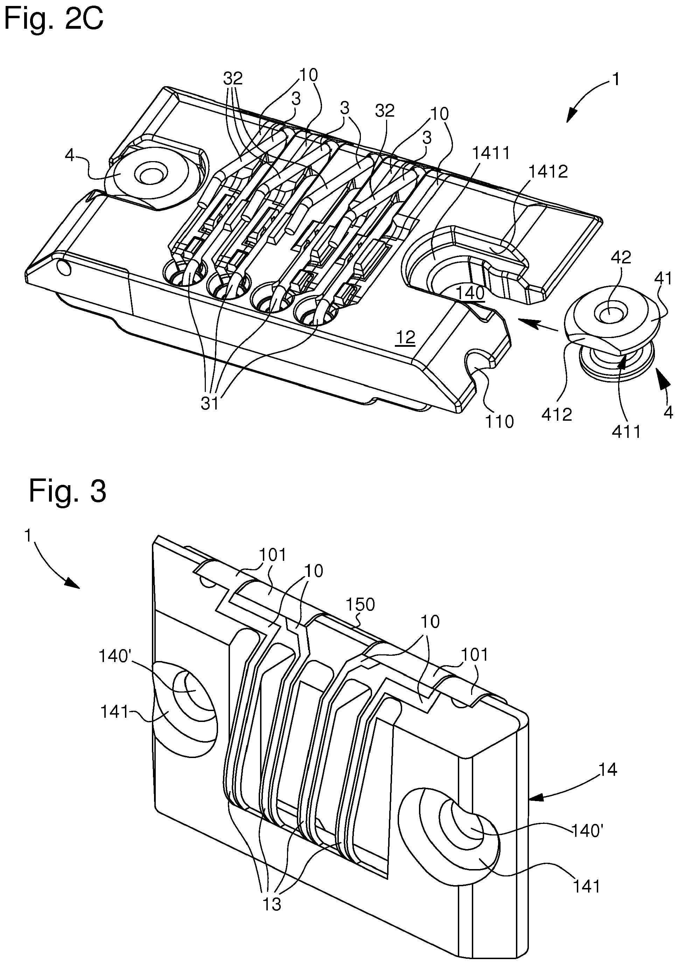

Les figures 1A-1B et 2A-2C montrent un support de capteur 1 selon un premier mode de réalisation préférentiel de l'invention, et la figure 3 montre un support de capteur 1 selon un deuxième mode de réalisation préférentiel de l'invention.

Selon chacun des deux modes de réalisation préférentiels, le support 1 comprend une première interface de connexion rigide vers le capteur 2, et une deuxième interface de connexion souple vers un circuit intégré, et ce afin de pouvoir récupérer des jeux de fonctionnement souvent critiques dans le domaine de l'horlogerie et ainsi garantir le contact avec le circuit intégré de commande.

Sur la figure 1A, le support de capteur 1 est montré vu du côté d'une première face 11 sur laquelle est agencée l'interface de connexion avec le capteur 2, pour lequel un logement 21 est prévu au centre. Au niveau du logement 21, des premiers trous traversants 16 sont prévus pour former des clips de fixation 18 sur la face opposée lors du moulage du support de capteur 1, visibles sur les figures 2A-2C suivantes, tandis que des deuxièmes trous traversants 17 sont agencés en dessous pour assurer une double sécurité de fixation et de connexion, comme cela est expliqué plus loin sur la base de ces mêmes figures 2A-2C. A une extrémité des pistes de connexion électriques 10, qui sont ici de préférence structurées au laser, on distingue des connecteurs 102 carrés disposés au niveau de la périphérie du logement 21 pour raccorder le capteur 2, tandis que sur l'arête supérieure du support 1 on distingue des portions élargies 101 des pistes de connexion électriques 10 disposées dans des dégagements 15 agencés symétriquement autour d'une saillie centrale 150. Ces portions élargies visent à faciliter la mise en oeuvre de tests électriques des supports et à faciliter la bonne interconnexion des pistes à travers le processus de structuration des pistes par laser, tandis que l'agencement de ces pistes élargies 101 dans des dégagements 15 au niveau d'une arête du support vise à les protéger de toute détérioration intempestive, notamment par abrasion, lors du transport et/ou la manipulation du support 1. On peut ainsi recourir à une technique de transport en vrac des supports 1 optimisant les rendements sans pour autant risquer de porter atteinte aux propriétés de conduction électrique du support 1.

Sur le flanc gauche du support est agencé un premier détrompeur laser 110 pour un positionnement correct lors de la structuration laser des pistes. A gauche de la cavité 21 se trouve un rond qui sert de détrompeur visuel pour le montage correct du support. Ce deuxième détrompeur de montage 19 a ici la forme d'un creux. Au milieu et de chaque côté de la première face 11 du support 1 se trouvent des éléments de fixation 14 destinés au montage du support 1 sur le boîtier de la montre; selon le premier mode de réalisation préférentiel décrit ces éléments de fixation 14 au boîtier prennent la forme d'échancrures 140 qui sont prévues pour coopérer avec des pieds de fixation 4 décrits plus loin et visibles sur les figures 2B-2C.

La figure 1B montre le support de capteur 1 illustré sur la figure 1A, c'est à dire vu du côté de la première face 11, sur laquelle est désormais monté le capteur 2 dans sa partie centrale. Toutes les références de la figure 1B, hormis le capteur 2, sont déjà illustrées sur la figure 1A (éléments de fixation 14 sous la forme des échancrures 140, deuxièmes trous traversants 17, pistes de connexion 10 et portions élargies 101, dégagements 15 et saillie centrale 150) et ont ainsi déjà été décrites.

Les figures 2A à 2C montrent le support de capteur 1 vu depuis une deuxième face 12, qui constitue la face opposée à la première face 11 illustrée sur les figures 1A et 1B. Sur la figure 2A, sur laquelle on distingue toujours le premier détrompeur laser 110, les pistes de connexion électriques 10 structurées au laser ainsi que les dégagements 15 et la saillie centrale 150, on peut voir que les échancrures 140 de fixation sont pourvues, de l'autre côté, d'un épaulement 141 qui présente d'un part une surface d'appui 1411 pour le montage des pieds de fixation 4 visibles sur la figure 2C ainsi qu'une surface de verrouillage en rotation 1412, c'est-à-dire les parois verticales et rectilignes qui permettent d'empêcher à toute pièce de fixation logée dans l'échancrure 140 et sur l'épaulement d'être entraînée en rotation, par exemple lors d'une opération de vissage.

Sur la figure 2A, on distingue par ailleurs, au centre du capteur 1, des creusures sont aménagées pour recevoir des ressorts fils 3, dont l'un est visible sur la figure 2B et tous, en position montée, sur la figure 2C. Chacune de ces creusures est bordée par une série de clips 18, qui permettent de monter les ressorts-fils 3 au support 1 de capteur. Les ressorts-fils 3 sont d'abord pris en tenaille entre deux clips 18 adjacents bordant une creusure, puis ensuite forcés vers l'intérieur, les clips 18 permettant alors de les maintenir plaqués dans leur logement. Au niveau de chacun des 4 deuxièmes trous traversants 17 sont agencés des oeillets 103 de connexion destinés à être connectés électriquement à chacun des ressorts fils 3.

La figure 2B illustre la même deuxième face 12 du support de capteur 1 illustré à la figure 2A, lors du montage d'un ressort fil 3 à l'intérieur d'un deuxième trou traversant 17. Toutes les références sont identiques à celles déjà été décrites sur la base de la figure 2A, hormis le ressort fil 3 prévu pour former l'interface de connexion souple vers un circuit intégré de commande positionné ailleurs dans le boîtier. Le ressort fil 3 présente une forme particulière courbée, quasiment à 180 degrés, une première partie 31 étant destinée à être fixée au support de capteur 1 en étant confinés dans les creusures et retenus pas les clips 18, tandis qu'une deuxième partie 32, dont l'extrémité est libre et flexible, est celle qui sera connectée au circuit intégré de commande et pourra récupérer des jeux de fonctionnement. Schématiquement, la première partie 31 du ressort fil constitue donc la partie de connexion au support de capteur 1 réalisé en 3D/MID, tandis que la deuxième partie 32 du ressort fil 3 est celle qui constitue la partie de connexion au circuit intégré. Bien que d'autres formes géométriques soient possibles, la forme particulière en épingle à cheveu selon le mode de réalisation préférentiel illustré permet de fournir une surface de contact maximale au niveau de chacune des interfaces de connexion, c'est-à-dire vers le circuit intégré et vers le support de capteur, tout en présentant une robustesse suffisante au niveau de l'articulation entre chacune des parties de connexion pour récupérer des jeux de fonctionnement si nécessaire, et parallèlement exercer une force de rappel d'intensité suffisante pour plaquer la deuxième partie 32 en contact vers une pièce de contact avec le circuit intégré lorsque les première et deuxièmes parties 31,32 sont rapprochées l'une de l'autre.

Afin d'améliorer encore à la fois la fixation des ressorts fils 3 au support 1 de capteur et également fournir une redondance des contacts électriques, par exemple de cas de choc violent tendant à déplacer légèrement la première partie 31 des ressorts fils 3 fixés au support, il est prévu, selon le mode de réalisation préférentiel décrit, de souder l'extrémité inférieure du ressort fil 3, recourbée ici à 90 degrés vers le bas de la première partie 31 fixée au support 1 et qui est amenée en contact avec les oeillets 103 de connexion, au niveau de l'extrémité supérieure des deuxièmes trous traversants 17. Selon une variante, l'extrémité du ressort fil 3 pourrait également être collée dans le deuxième trou traversant 17 au moyen d'un adhésif électriquement conducteur, notamment des adhésifs conducteurs à base de silicone, aux propriétés thixotropes, qui ne risquent pas de couler, y compris durant le processus de polymérisation, contrairement à un alliage classique d'étain utilisé pour le soudage et qui se liquéfie totalement lors de cette opération, de telle sorte qu'il est plus difficile de maîtriser la qualité et la fiabilité à long terme de la zone soudée. Un avantage supplémentaire d'un adhésif conducteur en silicone est sa souplesse mécanique, qui peut rendre l'assemblage plus robuste aux contraintes mécaniques, chocs ou vibrations, au contraire d'une soudure à l'étain qui reste très rigide et peut par exemple se fissurer lors de contraintes mécaniques. Enfin l'usage d'un adhésif conducteur présente l'avantage de polymériser à des températures plus basses que le point de fusion de l'étain (env. 130°C contre 250°C), de telle sorte que le risque d'endommager le plastique de la pièce support moulée est écarté, contrairement à lors d'une opération de soudage.

On peut également imaginer, dans une utilisation ultérieure du support de capteur 1 selon l'invention, remplacer les ressorts fils 3 par des versions qui auraient une partie 32 plus longue ou plus courte, de manière à être plus souple quant à la position de connexion au PCB.

Sur la figure 2C, on peut voir tous les ressorts-fils 3 en position assemblée au support 1 de capteur 2, ainsi que les pieds de fixation 4, qui comprennent une collerette cylindrique tronquée 41 qui vient s'emboîter sur l'épaulement 141 de l'échancrure 140 une fois que la partie cylindrique des pieds y ont été engagés et clipsés par l'extérieur. La collerette cylindrique tronquée 41 comprend, comme l'épaulement 141 de l'échancrure 140 de fixation, une surface de butée axiale 141 qui peut être maintenue en contact contre la surface d'appui axiale 1411 de l'épaulement, ainsi qu'une surface de verrouillage en rotation 412, qui est formée par la paroi rectiligne verticale de la partie tronquée de la collerette 41. Le pied de fixation 4 gauche est montré en position assemblée au support, tandis que le pied de fixation 4 droit est montré lors de son clipsage dans l'échancrure de fixation. Cette structure de fixation avec des pieds 4 et des échancrures 140 de forme particulière permet avantageusement de fixer le support 1 de capteur par exemple depuis l'extérieur du boîtier, des vis pouvant être introduites dans les ouvertures centrales 42 de chaque pied 4. Un tel mode de fixation par l'extérieur du boîtier - moyennant un perçage de la paroi du boîtier - est évidemment avantageux par rapport à un mode de fixation par l'intérieur du boîtier, où le manque de place et l'encombrement éventuel par diverses pièces rend toute opération de vissage rapidement relativement malcommode. Par ailleurs, ce mode d'assemblage avec des pieds de fixation 4 permet d'avoir une liberté de positionnement accrue du support 1 dans la direction perpendiculaire au plan de la deuxième face 12, rendant ainsi tout l'assemblage robuste aux décalages de montage du capteur dans cette direction radiale perpendiculaire à une paroi du boîtier. En effet, il n'y a ainsi jamais de surcontraintes latérales sur les vis de fixation et les joints correspondants, ce qui permet d'assurer l'étanchéité de la montre dans tous les cas de figure.

La figure 3 illustre un autre mode de réalisation préférentiel pour le capteur 1 selon l'invention, dans lequel l'interface de connexion souple vers le circuit intégré n'est plus formé par des ressorts fils, mais par des doigts flexibles 13 formé d'un bloc avec le reste du capteur 3D/MID, et sur lesquels sont directement agencées des pistes de connexion électriques 10, structurées au laser ou obtenue par exemple par injection bi-matière. Selon ce mode de réalisation, le processus de fabrication du support de capteur est ainsi encore simplifié; toutefois un tel mode de fabrication présente des inconvénients, sur le long terme, en termes de qualité de connexion car les doigts de connexion 13 sont susceptibles de s'user au niveau de l'articulation avec le corps du capteur, les pistes de connexion électriques 10 pouvant être très détériorées à ce niveau, voire même interrompues. Une autre différence entre ce deuxième mode de réalisation préférentiel et celui illustré aux figures précédentes concerne le mode de fixation au boîtier, puisqu'on peut constater que le support n'est plus pourvu d'échancrures 140 latérales mais de trous traversants 140', dont la forme cylindrique permet l'introduction d'une tête de vis par l'intérieur pour la fixation au boîtier. Comme discuté précédemment, cette variante pour la fixation présente l'inconvénient d'être plus délicate, mais toutefois l'avantage de requérir une pièce de moins et par conséquent une économie de coût unitaire, à défaut d'une amélioration du rendement de production. Comme pour le mode de réalisation illustré par les figures 1A-B et 2A-C, on pourra toutefois noter que les sections élargies 101 des pistes de connexion électriques 10 ainsi que leur agencement dans des dégagements 15 symétriquement disposés autour d'une saillie centrale 150 ont été conservés pour faciliter les tests électriques et protéger les pistes lors d'un traitement en vrac éventuel des supports 1.

## Revendications

1. Support (1) pour capteur (2) d'une pièce d'horlogerie, ledit support étant réalisé en 3D/MID ,de telle sorte qu'il présente une forme en trois dimensions et des pistes de connexion électrique (10) intégrées, et comprenant par ailleurs une première interface de connexion rigide **caractérisé en ce qu'**il comprend une deuxième interface de connexion souple formée par des ressorts fils (3) recourbés assemblés audit support ou par des doigts flexibles (13) sur lesquels sont agencées lesdites pistes de connexion électriques (10)

2. Support (1) pour capteur (2) d'une pièce d'horlogerie selon la revendication 1, **caractérisé en ce que** ledit ressort fil (3) recourbé comprend une première partie (31) fixée audit support (1) et une deuxième partie (32) libre et flexible.

3. Support (1) pour capteur (2) d'une pièce d'horlogerie selon la revendication 1 ou 2, **caractérisé en ce qu'**il comprend des clips (18) pour l'assemblage dudit ressort fil (3) recourbé.

4. Support (1) pour capteur (2) d'une pièce d'horlogerie selon l'une des revendications 1 à 3, **caractérisé en ce qu'**il comprend des deuxièmes trous traversants (17) dans lesquels lesdites pistes de connexion électriques (10) forment des oeillets (103) destinés à être connectés électriquement audit ressort fil (3).

5. Support (1) pour capteur (2) d'une pièce d'horlogerie selon la revendication 3 ou 4, **caractérisé en ce qu'**une extrémité dudit ressort fil (3) recourbé est soudé dans ledit deuxième trou traversant (17).

6. Support (1) pour capteur (2) d'une pièce d'horlogerie selon la revendication 3 ou 4, **caractérisé en ce qu'**une extrémité dudit ressort fil (3) recourbé est collé dans ledit deuxième trou traversant (17) au moyen d'un adhésif électriquement conducteur.

7. Support (1) pour capteur (2) d'une pièce d'horlogerie selon l'une des revendications précédentes, **caractérisé en ce que** lesdites pistes de connexion électrique (10) comprennent des portions élargies (101) disposées dans des dégagements (15) agencés sur une arête dudit support (1).

8. Support (1) pour capteur (2) d'une pièce d'horlogerie selon l'une des revendications précédentes, **caractérisé en ce qu'**il comprend un premier détrompeur (19) pour le montage et une série de deuxièmes détrompeurs (110) laser pour l'usinage des pistes de connexion électriques (10).

9. Support (1) pour capteur (2) d'une pièce d'horlogerie selon l'une des revendications précédentes, **caractérisé en ce qu'**il comprend une échancrure de fixation (140) présentant un épaulement (141) comprenant une surface d'appui axiale (1411) et une surface de verrouillage en rotation (1412).

10. Pièce d'horlogerie comprenant un module capteur formé d'un capteur (2) monté sur un support (1) selon l'une des revendications précédentes, **caractérisée en ce que** ledit support (1) est assemblé à une paroi interne du boîtier de ladite pièce d'horlogerie à l'aide de pieds de fixation (4).

## Patentansprüche

1. Träger (1) für einen Sensor (2) eines Zeitmessgeräts, wobei der Träger in 3D/MID ausgebildet ist, derart, dass er eine dreidimensionale Form und integrierte elektrische Anschlussbahnen (10) aufweist und außerdem eine erste starre Anschlussschnittstelle umfasst, **dadurch gekennzeichnet, dass** er eine zweite nachgiebige Anschlussschnittstelle umfasst, die durch gekrümmte Drahtfedern (3), die an den Träger angefügt sind, oder durch biegsame Finger (13), auf denen die elektrischen Anschlussbahnen (10) angeordnet sind, gebildet ist.

2. Träger (1) für einen Sensor (2) eines Zeitmessgeräts nach Anspruch 1, **dadurch gekennzeichnet, dass** die gekrümmte Drahtfeder (3) einen ersten Teil (31), der an dem Träger (1) befestigt ist, und einen freien und biegsamen zweiten Teil (32) umfasst.

3. Träger (1) für einen Sensor (2) eines Zeitmessgeräts nach Anspruch 1 oder 2, **dadurch gekennzeichnet, dass** er Klemmen (18) für die Anfügung der gekrümmten Drahtfeder (3) umfasst.

4. Träger (1) für einen Sensor (2) eines Zeitmessgeräts nach einem der Ansprüche 1 bis 3, **dadurch gekennzeichnet, dass** er zweite Durchgangslöcher (17) umfasst, in denen die elektrischen Anschlussbahnen (10) Ösen (103) bilden, die dazu bestimmt sind, mit der Drahtfeder (3) elektrisch verbunden zu werden.

5. Träger (1) für einen Sensor (2) eines Zeitmessgeräts nach Anspruch 3 oder 4, **dadurch gekennzeichnet, dass** ein Ende der gekrümmten Drahtfeder (3) in dem zweiten Durchgangsloch (17) verlötet ist.

6. Träger (1) für einen Sensor (2) eines Zeitmessgeräts nach Anspruch 3 oder 4, **dadurch gekennzeichnet, dass** ein Ende der gekrümmten Drahtfeder (3) in das zweite Durchgangsloch (17) mittels eines elektrisch leitenden Klebstoffs geklebt ist.

7. Träger (1) für einen Sensor (2) eines Zeitmessgeräts nach einem der vorhergehenden Ansprüche, **dadurch gekennzeichnet, dass** die elektrischen Anschlussbahnen (10) verbreiterte Abschnitte (101) aufweisen, die in Aussparungen (15) angeordnet sind, die an einer Kante des Trägers (1) angeordnet sind.

8. Träger (1) für einen Sensor (2) eines Zeitmessgeräts nach einem der vorhergehenden Ansprüche, **dadurch gekennzeichnet, dass** er eine erste Codierung (19) für den Zusammenbau und eine Reihe zweiter Laser-Codierungen (110) für die Formgebung der elektrischen Anschlussbahnen (10) umfasst.

9. Träger (1) für einen Sensor (2) eines Zeitmessgeräts nach einem der vorhergehenden Ansprüche, **dadurch gekennzeichnet, dass** er eine Befestigungsaussparung (140) aufweist, die eine Schulter (141) aufweist, die eine axiale Abstützoberfläche (1411) und eine Drehverriegelungsfläche (1412) umfasst.

10. Zeitmessgerät, das ein Sensormodul umfasst, das aus einem auf einem Träger (1) nach einem der vorhergehenden Ansprüche angeordneten Sensor (2) gebildet ist, **dadurch gekennzeichnet, dass** der Träger (1) an einer Innenwand des Gehäuses des Zeitmessgeräts mit Hilfe von Befestigungsfüßen (4) angebracht ist.

## Claims

1. Support element (1) for a timepiece sensor (2), said support element being made in 3D/MID, so that the support element has a three-dimensional shape and integrated electrical connection paths (10), and further including a first rigid connection interface, **characterized in that** the support element includes a second, flexible connection interface formed by bent wire springs (3) assembled to said support, or by flexible finger-pieces (13) on which are arranged said electrical connection paths (10).

2. Support element (1) for a timepiece sensor (2) according to claim 1, **characterized in that** said bent wire spring (3) includes a first portion (31) secured to said support element (1) and a second, flexible, free portion (32).

3. Support element (1) for a timepiece sensor (2) according to claim 1 or 2, **characterized in that** the support element includes clips (18) for the assembly of said bent wire spring (3).

4. Support element (1) for a timepiece sensor (2) according to any of claims 1 to 3, **characterized in that** the support element includes second via holes (17) in which said electrical connection paths (10) form eyelets (103) intended to be electrically connected to said wire spring (3).

5. Support element (1) for a timepiece sensor (2) according to claim 3 or 4, **characterized in that** one end of said bent wire spring (3) is soldered in said second via hole (17).

6. Support element (1) for a timepiece sensor (2) according to claim 3 or 4, **characterized in that** one end of said bent wire spring (3) is bonded in said second via hole (17) by means of an electrically conductive adhesive.

7. Support element (1) for a timepiece sensor (2) according to any of the preceding claims, **characterized in that** said electrical connection paths (10) include enlarged portions (101) disposed in recesses (15) arranged on one edge of said support element (1).

8. Support element (1) for a timepiece sensor (2) according to any of the preceding claims, **characterized in that** the support element includes a first guide mark (19) for assembly and a series of second laser guide marks (110) for machining the electrical connection paths (10).

9. Support element (1) for a timepiece sensor (2) according to any of the preceding claims, **characterized in that** the support element includes a securing notch (140) having a shoulder (141) including an axial bearing surface (1411) and a rotation lock surface (1412).

10. Timepiece including a sensor module formed of a sensor (2) mounted on a support element (1) according to any of the preceding claims, **characterized in that** said support element (1) is assembled to an internal wall of the case of said timepiece with the aid of mounting feet (4).
